# EUROPEAN PATENT APPLICATION

(11) **EP 4 203 031 A1**
(43) Date of publication of application: **28.06.2023**
(21) Application number: 22770202.4
(22) Date of filing: 25.01.2022
(51) Int. Cl.: H01L 25/16, H01L 23/66, H01L 21/78, H01L 21/50, H01Q 1/22

(54) **CRYSTAL GRAIN MANUFACTURING METHOD**

(30) Priority: 16.03.2021 CN 202110278395
(71) Applicant: Honor Device Co., Ltd., Shenzhen, Guangdong 518040 (CN)
(72) Inventor: HUANG, Qinghua, Shenzhen, Guangdong 518040 (CN); LIU, Gang, Shenzhen, Guangdong 518040 (CN)
(74) Representative: Epping - Hermann - Fischer
(86) International application number: PCT/CN2022/073736
(87) International publication number: WO 2022/193842

(57) **Abstract**

Embodiments of this application provide a method for manufacturing a die, in which minimum repetitive functional cells in M modules with the same functional cell are defined as minimum standard cells, and in this way, minimum standard cells with the same function may be combined and reused when different modules are made, so that a quantity of wafer types may be reduced, and problems such as a long development cycle and difficulty in stocking of wafers may be resolved.

## Description

This application claims priority to Chinese Patent Application No. 202110278395.1, filed with the China National Intellectual Property Administration on March 16, 2021 and entitled "DIE, MODULE, WAFER, AND METHOD FOR MANUFACTURING DIE", which is incorporated herein by reference in its entirety.

### TECHNICAL FIELD

This application relates to the field of chip technologies, and in particular, to a method for manufacturing a die.

### BACKGROUND

As electronic devices are constantly updated, modules in the electronic devices have developed rapidly, and different modules can implement different functions. For example, a system in package module (system in package module, SIP module) may include functions such as power supply, baseband, storage, and radio frequency, where a radio frequency (radio frequency, RF) SIP module is a radio frequency functional module configured to implement radio frequency transmitting and receiving functions, and the like.

Generally, a SIP module interconnects different dies, RCL components, and the like on a substrate, so that the SIP module may implement a function. Because the dies are cut from wafers, different wafers need to be designed for different SIP modules.

However, different modules generally include functional cells with different functions, and a wafer needs to be designed for each functional cell, which increases development costs of the wafers, resulting in a long development cycle and difficulty in stocking of the wafers.

### SUMMARY

Embodiments of this application provide a method for manufacturing a die, in which minimum repetitive functional cells in M modules with the same functional cell may be defined as minimum standard cells, and in this way, minimum standard cells with the same function may be combined and reused in different modules, so that a quantity of wafer types may be reduced, and problems such as a long development cycle and difficulty in stocking of wafers may be resolved. According to a first aspect, an embodiment of this application provides a die for making M modules, where the M modules are configured to implement radio frequency transmitting or receiving functions in different mobile systems, and the die includes: N minimum standard cells with the same function; and the minimum standard cells are used to make the M modules; where M is greater than 1, N is greater than or equal to 1, and the minimum standard cells are minimum repetitive functional cells in the M modules with the same functional cell.

According to the die provided in this embodiment of this application, the minimum standard cells included in the die may be reused in different modules, so that a quantity of wafer types may be reduced, and problems such as a long development cycle and difficulty in stocking of wafers may be resolved.

In a possible implementation, pads with the same function of the N minimum standard cells with the same function are respectively connected to each other in the die, where N is greater than 1. In this way, a quantity of wires between the die and module pins may be reduced.

In a possible implementation, a scribing channel is disposed between two adjacent minimum standard cells, and pads with the same function of the adjacent minimum standard cells are electrically connected respectively through the scribing channel. In this way, an electrical connection function may be implemented between adjacent minimum standard cells in the same die.

In a possible implementation, the minimum standard cells include any one of: a filter cell, an amplifier cell, or a switch cell.

According to a second aspect, an embodiment of this application provides a module. The module includes a substrate and a first die; the first die includes N first minimum standard cells with the same function, and pads with the same function of the N first minimum standard cells with the same function are respectively connected to each other in the first die; the first die is disposed on the substrate; a pin of the substrate is connected to a pad of any one of the first minimum standard cells; where N is greater than 1, the first minimum standard cells are minimum repetitive functional cells in the M modules with the same functional cell, and M is greater than 1.

In a possible implementation, a scribing channel is disposed between two adjacent first minimum standard cells, and pads with the same function of the adjacent first minimum standard cells are electrically connected respectively through the scribing channel. In this way, an electrical connection function may be implemented between adjacent minimum standard cells in the same die.

In a possible implementation, the module further includes a second die; and the second die includes one or more second minimum standard cells with the same function. In this way, based on the second minimum standard cells, different functions of the module may be implemented.

In a possible implementation, the first minimum standard cells include any one of: a filter cell, an amplifier cell, or a switch cell.

According to a third aspect, an embodiment of this application provides a wafer. The wafer includes X minimum standard cells with the same function; among the X minimum standard cells with the same function, a scribing channel is disposed between two adjacent minimum standard cells; pads with the same function of the adjacent minimum standard cells are electrically connected respectively through the scribing channel; where X is greater than or equal to 2; and the minimum standard cells are minimum repetitive functional cells in the M modules with the same functional cell, where M is greater than 1.

In a possible implementation, the minimum standard cells include any one of: a filter cell, an amplifier cell, or a switch cell.

According to a fourth aspect, an embodiment of this application provides a method for manufacturing a die, including: providing a wafer, where the wafer includes X minimum standard cells with the same function, a scribing channel is disposed between two adjacent minimum standard cells among the X minimum standard cells with the same function, and pads with the same function of the adjacent minimum standard cells are electrically connected respectively through the scribing channel; and cutting the wafer to obtain a first die, where the first die includes K minimum standard cells, and K is an integer greater than or equal to 1.

In a possible implementation, the method further includes: cutting the wafer to obtain a second die, where the second die includes L minimum standard cells with the same function, L is an integer greater than or equal to 1, and L and K are not equal.

In a possible implementation, the minimum standard cells include any one of: a filter cell, an amplifier cell, or a switch cell.

According to a fifth aspect, an embodiment of this application provides a method for simultaneously making M modules, where the M modules include different dies and are configured to implement radio frequency transmitting or receiving functions in different mobile systems, and the method includes: dividing the M modules by functions, where different functions are implemented by different dies, the dies include one or more minimum standard cells with the same function, the minimum standard cells are minimum repetitive functional cells in the M modules with the same functional cell, M is greater than 1, and each of the M modules includes different dies; cutting G wafers to obtain G dies, where the G dies are used to implement G functions respectively, and G is greater than 1; and combining and reusing a plurality of dies of the G dies to make the M modules respectively.

In a possible implementation, among the minimum standard cells with the same function, pads with the same function are respectively connected to each other in the dies by metal wiring for an integrated circuit process.

In a possible implementation, a scribing channel is disposed between two adjacent minimum standard cells, and pads with the same function of the adjacent minimum standard cells are electrically connected respectively through the scribing channel.

In a possible implementation, the minimum standard cells include any one of: a filter cell, an amplifier cell, or a switch cell.

According to a sixth aspect, an embodiment of this application provides a radio frequency system, including an antenna and the foregoing module.

The radio frequency system provided in this embodiment of this application includes an antenna and a module, the module may be made of different dies, and minimum standard cells with the same function included in the dies may be reused in different modules, so that a quantity of wafer types may be reduced, and problems such as a long development cycle and difficulty in stocking of wafers may be resolved.

These and other aspects, implementations, and advantages of the example embodiments will become apparent from embodiments described hereinafter with reference to the accompanying drawings. However, it should be understood that the specification and the accompanying drawings are only used for description and are not used as a definition of limitation on embodiments of this application. For details, refer to the appended claims. Other aspects and advantages of embodiments of this application will be described in the following descriptions, and some of which will be obvious from the description, or may be learned from practice of embodiments of this application. In addition, all aspects and advantages of embodiments of this application may be implemented and obtained by using means and combinations specifically indicated in the appended claims.

### BRIEF DESCRIPTION OF DRAWINGS

FIG. 1 is a schematic diagram of a SIP module in the conventional technology;
FIG. 2 is a schematic diagram of an N77 single-frequency receiving module in the conventional technology;
FIG. 3 is a schematic diagram of an N79 single-frequency receiving module in the conventional technology;
FIG. 4 is a schematic diagram of a dual-frequency one-way receiving module in the conventional technology;
FIG. 5 is a schematic diagram of a dual-frequency two-way receiving module in the conventional technology;
FIG. 6 is a schematic diagram of a wafer type in the conventional technology;
FIG. 7 is a schematic diagram of a wafer type in the conventional technology;
FIG. 8 is a schematic diagram of a wafer type in the conventional technology;
FIG. 9 is a schematic diagram of a wafer type in the conventional technology;
FIG. 10 is a schematic diagram of a layout and a wiring of a SIP module substrate in the conventional technology;
FIG. 11 is a schematic diagram of a die according to an embodiment of this application;
FIG. 12 is a schematic diagram of a layout wiring according to an embodiment of this application;
FIG. 13 is a schematic diagram of a scribing channel according to an embodiment of this application;
FIG. 14 is a schematic diagram of a layout wiring according to an embodiment of this application;
FIG. 15 is a schematic diagram of a module according to an embodiment of this application;
FIG. 16 is a schematic diagram of a layout wiring according to an embodiment of this application;
FIG. 17 is a schematic diagram of a module according to an embodiment of this application;
FIG. 18 is a schematic diagram of a wafer according to an embodiment of this application;
FIG. 19 is a schematic diagram of a wafer cutting method according to an embodiment of this application;
FIG. 20 is a schematic diagram of a wafer cutting method according to an embodiment of this application;
FIG. 21 is a schematic diagram of a wafer cutting method according to an embodiment of this application;
FIG. 22 is a schematic diagram of a wafer cutting method according to an embodiment of this application;
FIG. 23 is a schematic diagram of a wafer cutting method according to an embodiment of this application;
FIG. 24 is a schematic diagram of a wafer cutting method according to an embodiment of this application;
FIG. 25 is a schematic diagram of a wafer cutting method according to an embodiment of this application;
FIG. 26 is a schematic diagram of a wafer cutting method according to an embodiment of this application;
FIG. 27 is a schematic diagram of a wafer cutting method according to an embodiment of this application;
FIG. 28 is a schematic diagram of a method for manufacturing a die according to an embodiment of this application;
FIG. 29 is a schematic diagram of a method for manufacturing a die according to an embodiment of this application;
FIG. 30 is a schematic diagram of a wafer type according to an embodiment of this application;
FIG. 31 is a schematic diagram of a wafer type according to an embodiment of this application;
FIG. 32 is a schematic diagram of a wafer type according to an embodiment of this application; and
FIG. 33 is a schematic diagram of a wafer type according to an embodiment of this application.

### DESCRIPTION OF EMBODIMENTS

To clearly describe technical solutions in embodiments of this application, in embodiments of this application, words such as "first" and "second" are used to distinguish between same items or similar items with basically the same functions and effects. For example, a first die and a second die are merely intended to distinguish between different dies, but not to limit a sequence thereof. A person skilled in the art may understand that words such as "first" and "second" do not limit a quantity and an execution sequence, and the words such as "first" and "second" do not indicate a difference.

It should be noted that in embodiments of this application, a word such as "example" or "for example" is used to represent an example, an illustration, or a description. Any embodiment or design solution described as "example" or "for example" in this application should not be construed as more preferred or advantageous than other embodiments or design solutions. To be precise, the use of the words such as "example" or "for example" is intended to present a related concept in a specific manner.

In embodiments of this application, "at least one" means one or more, and "a plurality of" means two or more. The term "and/or" describes an association relationship between associated objects, and indicates that three relationships may exist. For example, A and/or B may indicate the following cases: Only A exists, both A and B exist, and only B exits, where A and B may be singular or plural. The character "/" usually indicates an "or" relationship between the associated objects. "At least one of the following items" or a similar expression thereof means any combination of these items, including a single item or any combination of plural items. For example, at least one of a, b, or c may indicate a, b, c, a-b, a-c, b-c, or a-b-c, where a, b, and c may be singular or plural.

During communication between a mobile terminal and a base station, a radio frequency system may be used. The radio frequency system includes a system in package (system in package, SIP) module, so that the communication between the mobile terminal and the base station may be implemented based on the SIP module.

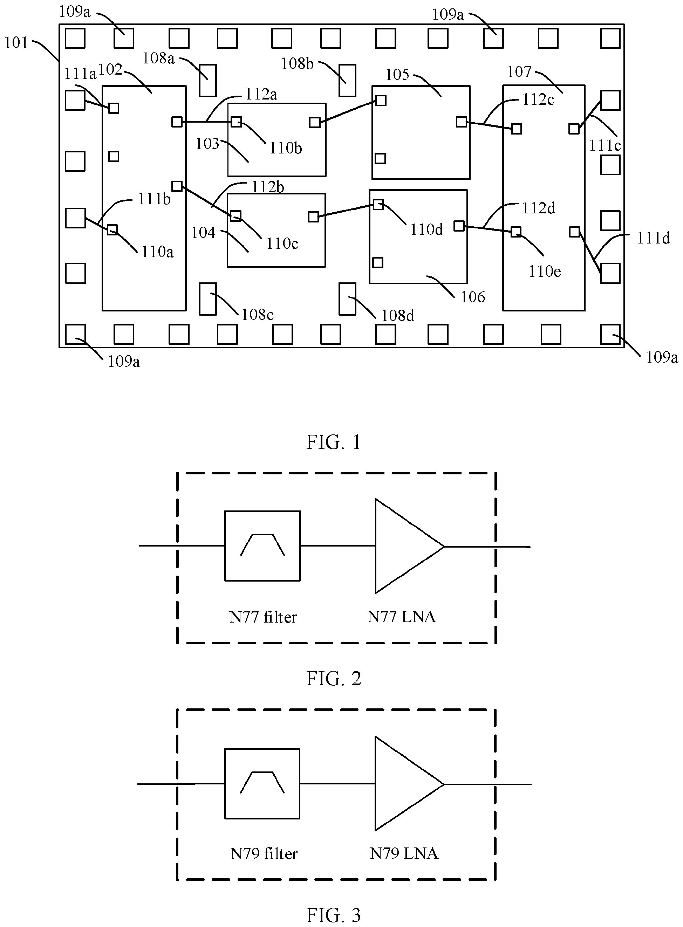

For example, FIG. 1 is a schematic diagram of a SIP module in the conventional technology. As shown in FIG. 1, the SIP module includes: a SIP substrate 101, an input switch die 102, an N77 band filter 103 (hereinafter referred to as an N77 filter), an N79 band filter 104 (hereinafter referred to as an N79 filter), an N77 band low noise amplifier (low noise amplifier, LNA) (hereinafter referred to as an N77 LNA) die 105, an N79 band LNA (hereinafter referred to as an N79 LNA) 106, an output switch die 107, matching elements 108a-d, module pins 109a-d, die pads 110a-e, substrate wires 111a-d, and substrate wires 112a-d, where the SIP module pins are not all labeled in FIG. 1, and the die pads are not all labeled in FIG. 1.

The input switch die 102 may be a DP3T switch die, the output switch die 107 may be a DPDT switch die, and the substrate wires 111a-d are wires between the die pads and the module pins, so that a signal may be output from the die pads to the module pins; and the substrate wires 112a-d are wires between one die pad and another die pad, so that a signal may be output from one die to another die.

Generally, the SIP module may include a transmitting module, a receiving module, a transceiving module, or the like. When a receiving module of Sub6G is used as an example, the receiving module may include an N77 single-frequency receiving module, an N79 single-frequency receiving module, a receiving module including N77 and N79, and the like. The receiving module including N77 and N79 may include a dual-frequency one-way receiving module or a dual-frequency two-way receiving module.

For example, FIG. 2 is a schematic diagram of an N77 single-frequency receiving module in the conventional technology. As shown in FIG. 2, the module includes a plurality of functional cells, and the functional cells may be N77 filters and N77 LNAs. The N77 filters may filter out signals other than signals having an operating frequency range of 3.3-4.2 GHz, or it may be understood that the N77 filters may select signals having an operating frequency range of 3.3-4.2 GHz, and that the N77 LNAs may amplify signals having an operating frequency range of 3.3-4.2 GHz.

In a possible case, if a base station of an operator A has an operating frequency range of 3.3-4.2 GHz, when a mobile terminal may only need to satisfy the operator A, the mobile terminal may process a signal received from the base station based on the receiving module shown in FIG. 2. For example, if the mobile terminal receives a relatively weak signal from the base station, and the signal contains other interference signals, the mobile terminal may select a frequency for the received signal by using the N77 filters, amplify the signal at the selected frequency by using the N77 LNAs, and transmit the amplified signal to a radio frequency transceiver (transceiver).

For example, FIG. 3 is a schematic diagram of an N79 single-frequency receiving module in the conventional technology. As shown in FIG. 3, the module includes a plurality of functional cells, and the functional cells may be N79 filters and N79 LNAs. The N79 filters may filter out signals other than signals having an operating frequency range of 4.4-5.0 GHz, or it may be understood that the N79 filters may select signals having an operating frequency range of 4.4-5.0 GHz, and that the N79 LNAs may amplify signals having an operating frequency range of 4.4-5.0 GHz.

In a possible case, if a base station of an operator B has an operating frequency range of 4.4-5.0 GHz, when a mobile terminal may only need to satisfy the operator B, the mobile terminal may process a signal received from the base station based on the receiving module shown in FIG. 3. For example, if the mobile terminal receives a relatively weak signal from the base station, and the signal contains other interference signals, the mobile terminal may select a frequency for the received signal by using the N79 filters, amplify the signal at the selected frequency by using the N79 LNAs, and transmit the amplified signal to a radio frequency transceiver.

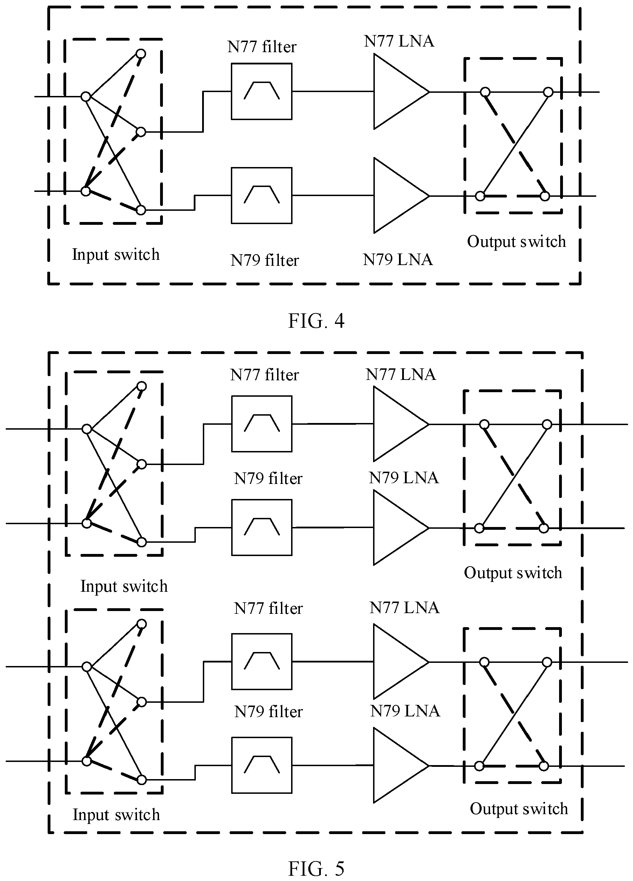

For example, FIG. 4 is a schematic diagram of a dual-frequency one-way receiving module in the conventional technology. The receiving module shown in FIG. 4 is a combination of the receiving module shown in FIG. 2 and the receiving module shown in FIG. 3. As shown in FIG. 4, the module includes a plurality of functional cells, and the functional cells may be an N77 filter, an N77 LNA, an N79 filter, an N79 LNA, an input switch, and an output switch. The input switch may be a double pole 3 throw (double pole 3 throw, DP3T) switch, and the output switch may be a double pole double throw (double pole double throw, DPDT) switch.

In a possible case, if a base station of an operator A has an operating frequency range of 3.3-4.2 GHz, and a base station of an operator B has an operating frequency range of 4.4-5.0 GHz, when a mobile terminal needs to satisfy both the operator A and the operator B, the mobile terminal may process a signal received from the base station based on the receiving module shown in FIG. 4. For example, the mobile terminal may enable, by using a DP3T switch, the received signal to select to enter a path in which the N77 filter and the N77 LNA are located, and to select to enter a path in which the N79 filter and the N79 LNA are located. In this way, the signal is processed by using the filters and the amplifiers, and is output to the pins of the module by using a DPDT switch, and then the processed signal is transmitted to a radio frequency transceiver.

On the basis of the receiving module shown in FIG. 4, for example, FIG. 5 is a schematic diagram of a dual-frequency two-way receiving module in the conventional technology. As shown in FIG. 5, a mobile terminal may receive signals from a base station by using four receiving channels, because when the mobile terminal needs to support 4*4 multiple-in multipleout (multiple-in multipleout, MIMO) (or referred to as 4*4 MIMO), the mobile terminal needs two receiving channels for two bands at a diversity receiving side and also needs two receiving channels for each band at a main receiving side. Therefore, a total of four receiving channels are needed for two bands N77 and N79.

In the receiving modules shown in FIG. 2 to FIG. 5, the filters may be implemented by using an integrated passive device (integrated passive device, IPD), a surface acoustic wave (surface acoustic wave, SAW) process or a bulk acoustic wave (bulk acoustic wave, BAW) process based on a semiconductor process, and the input switch or the output switch may be implemented by using a silicon on insulator (silicon on insulator, SOI) technology or a pseudomorphic high electron mobility transistor (pseudomorphic high electron mobility transistor, PHEMT) technology. Corresponding to the foregoing four receiving modules, because functional cells in different modules are different, wafers may be designed separately when the modules are designed, and the wafers include the functional cells. In this way, a quantity of wafer types in different receiving modules is different.

For ease of description, a wafer including an N77 filter is referred to as a wafer 1, a wafer including an N77 LNA is referred to as a wafer 2, a wafer including an N79 filter is referred to as a wafer 3, a wafer including an N79 LNA is referred to as a wafer 4, a wafer including an N77 filter and an N79 filter is referred to as a wafer 5, a wafer including an N77 LNA and an N79 LNA is referred to as a wafer 6, a wafer including an input switch and an output switch is referred to as a wafer 7, a wafer including two N77 filters and two N79 filters is referred to as a wafer 8, a wafer including two N77 LNA filters and two N79 LNA filters is referred to as a wafer 9, and a wafer including two input switches and two output switches is referred to as a wafer 10.

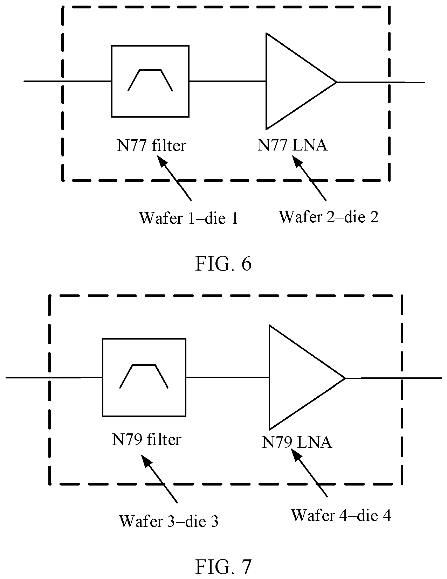

It should be noted that in FIG. 6 to FIG. 9, each type of die comes from a different wafer. The wafer 1 may be cut to obtain a die 1, the wafer 2 may be cut to obtain a die 2, the wafer 3 may be cut to obtain a die 3, the wafer 4 may be cut to obtain a die 4, the wafer 5 may be cut to obtain a die 5, the wafer 6 may be cut to obtain a die 6, the wafer 7 may be cut to obtain a die 7, the wafer 8 may be cut to obtain a die 8, the wafer 9 may be cut to obtain a die 9, and the wafer 10 may be cut to obtain a die 10.

With reference to the receiving module shown in FIG. 2, for example, FIG. 6 is a schematic diagram of a wafer type in the conventional technology. As shown in FIG. 6, it can be learned that two types of wafers (the wafer 1 and the wafer 2) are needed when the receiving module shown in FIG. 2 is made, or it may be understood that two dies (the die 1 and the die 2) are needed.

With reference to the receiving module shown in FIG. 3, for example, FIG. 7 is a schematic diagram of a wafer type in the conventional technology. As shown in FIG. 7, it can be learned that two types of wafers (the wafer 3 and the wafer 4) are needed when the receiving module shown in FIG. 3 is made, or it may be understood that two dies (the die 3 and the die 4) are needed.

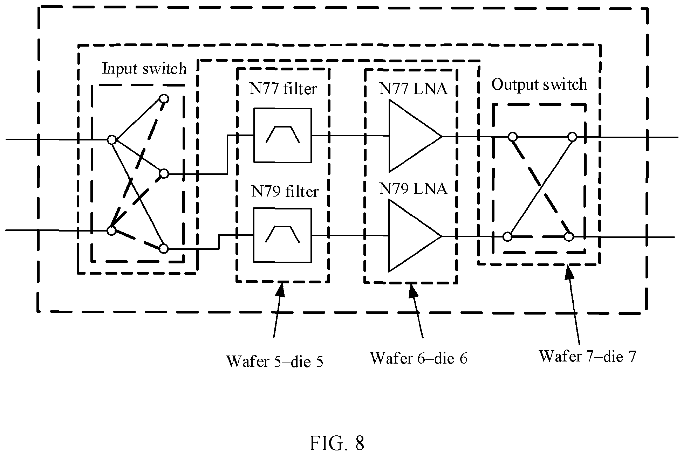

With reference to the receiving module shown in FIG. 4, for example, FIG. 8 is a schematic diagram of a wafer type in the conventional technology. As shown in FIG. 8, it can be learned that three types of wafers (the wafer 5, the wafer 6, and the wafer 7) are needed when the receiving module shown in FIG. 4 is made, or it may be understood that three dies (the die 5, the die 6, and the die 7) are needed. The wafer 5, the wafer 6, and the wafer 7 each include different functional cells.

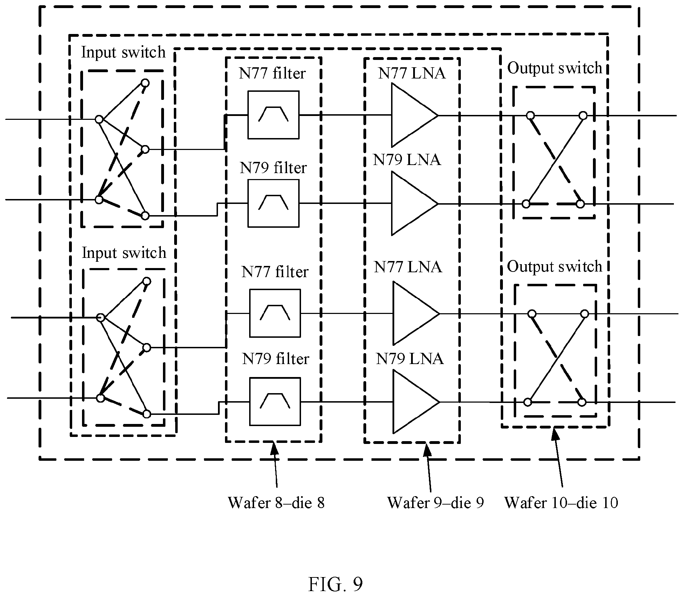

With reference to the receiving module shown in FIG. 5, for example, FIG. 9 is a schematic diagram of a wafer type in the conventional technology. As shown in FIG. 9, it can be learned that three types of wafers (the wafer 8, the wafer 9, and the wafer 10) are needed when the receiving module shown in FIG. 5 is made, or it may be understood that three dies (the die 8, the die 9, and the die 10) are needed. The wafer 8, the wafer 9, and the wafer 10 each include different functional cells.

According to the wafer types shown in FIG. 6 to FIG. 9, it can be learned that ten types of wafers are needed when the receiving modules shown in FIG. 2 to FIG. 5 are made. In a possible case, in the receiving module shown in FIG. 8 or FIG. 9, if an N77 LNA, an N79 LNA, an input switch, and an output switch are integrated on the same die based on an SOI process, or it may be understood that the LNAs and the switches are integrated simultaneously based on the SOIprocess, then a total quantity of wafer types needed to make the receiving modules shown in FIG. 2 to FIG. 5 is still greater than or equal to 8.

In the receiving modules shown in FIG. 2 to FIG. 5, functional cells in the modules need to be wired. The receiving modules shown in FIG. 2 to FIG. 5 are all SIP modules. For ease of description of a wiring relationship in the SIP modules, with reference to the dual-frequency one-way receiving module shown in FIG. 4, the receiving module is wired as follows: on a substrate 101, an input switch 102 is connected to pins of the substrate 101 by using substrate wires 111a and 11 1b, pads of the input switch 102 are connected to an N77 filter 105 by using a substrate wire 112a, the pads of the input switch 102 are connected to an N79 filter 106 by using a substrate wire 112b, pads of the N77 filter 105 are connected to an output switch 107 by using a substrate wire 112c, pads of the N79 filter 106 are connected to the output switch 107 by using a substrate wire 112d, and two pads of the output switch 107 are connected to the pins of the module by using substrate wires 111c and 111d, respectively.

Further, when dies are reused in the same module, a safe distance needs to be kept among the dies in consideration of a die mounting process. For example, the safe distance may be 100-150 microns (µm). In addition, each die needs to be wired to the pins of the module; where the reuse may be understood as repeated attaching of the same die on the module substrate.

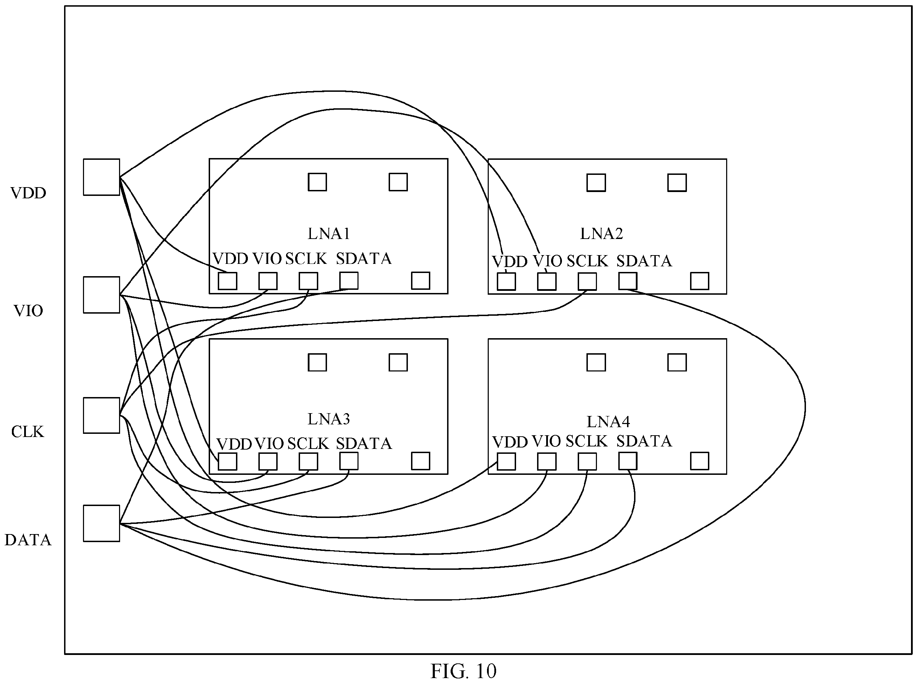

When using that four LNA dies are reused and control lines are mobile industry processor interface (mobile industry processor interface, MIPI) lines as an example, for example, FIG. 10 is a schematic diagram of a layout and a wiring of a SIP module substrate in the conventional technology. As shown in FIG. 10, because the MIPI lines include three lines: VIO, CLK, and DATA, and a power line VDD of the LNAs is used, there is a total of four control lines on the SIP module substrate. In this way, when four LNAs (four identical dies) are respectively connected to the pins of the module by using substrate wires, a quantity of the wires is 16. In addition, because the MIPI lines carry digital signals with high noise, to avoid interference with a radio frequency signal, the MIPI lines need to be shielded in a cladding manner, so that the 16 wires will occupy more module space.

According to the foregoing description, there are the following problems: on the one hand, when the receiving modules shown in FIG. 2 to FIG. 5 are made based on the wafer types shown in FIG. 6 to FIG. 9, development costs of wafers may be high and a feed preparation cycle may be long due to numerous types of the wafers, leading to difficulty in stocking of the wafers; in addition, different modules need different dies, and when the wafers are cut to obtain dies, cutting costs of the dies may be increased; and on the other hand, with reference to FIG. 10, when the dies are reused in the same module, because pads of different dies are respectively connected to pins of the module, a quantity of control wires on the module may be large, as a result, wires are complex and more module space is occupied; in addition, a spacing between the dies will also occupy the module space.

Based on this, an embodiment of this application provides a method for manufacturing a die, in which minimum repetitive functional cells in M modules with the same functional cell are defined as minimum standard cells, and in this way, minimum standard cells with the same function may be combined and reused when different modules are made, so that a quantity of wafer types may be reduced, and problems such as a long development cycle and difficulty in stocking of wafers may be resolved.

It should be noted that the method for manufacturing a die provided in this embodiment of this application may be applicable to a multi-die SIP module, and a specific quantity of dies may be set according to an actual application scenario. This is not limited in this embodiment of this application.

Specific structures of a die, a module, and a wafer will be described below with reference to the accompanying drawings.

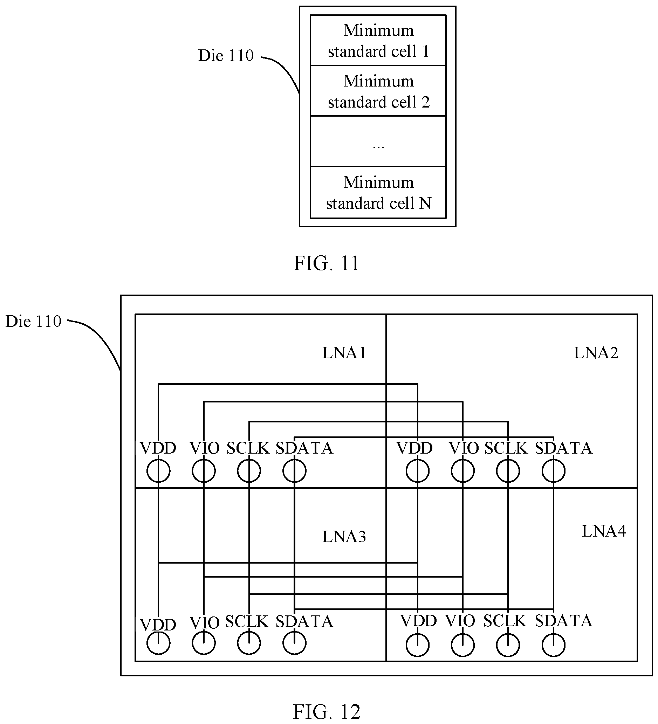

For example, FIG. 11 is a schematic diagram of a die 110 according to an embodiment of this application. As shown in FIG. 11, the die 110 includes: N minimum standard cells with the same function, where the N minimum standard cells with the same function are a minimum standard cell 1, a minimum standard cell 2, ..., and a minimum standard cell N, where N is greater than or equal to 1, and the minimum standard cells may each be a filter cell, an amplifier cell, or a switch cell.

In this embodiment of this application, the die 110 is used to make M modules, and each module includes dies with different functions, or it may be understood that the minimum standard cells are used to make M modules. The M modules are configured to implement radio frequency transmitting or receiving functions in different mobile systems. Therefore, the M modules may be receiving modules or transmitting modules. For example, using a receiving module of Sub6G as an example, the module may be the receiving modules shown in FIG. 2 to FIG. 5. It may be understood that a specific implementation for making the M modules from the minimum standard cells may be set according to an actual application scenario. This is not limited in this embodiment of this application.

In this embodiment of this application, the minimum standard cells are minimum repetitive functional cells in the M modules with the same functional cell, and the minimum repetitive functional cells may be understood as follows: by comparing the M modules, if the M modules each include a functional cell, minimum repetitive cells may be determined by analyzing a greatest common factor of a quantity of same functional cells in the M modules; where M is greater than 1.

For ease of description, when M=4, with reference to the four receiving modules shown in FIG. 2 to FIG. 5, minimum repetitive functional cells in the four modules can be known by analyzing characteristics of the four receiving modules, and then minimum standard cells may be determined. It can be learned from the analysis that the receiving modules described in FIG. 2 to FIG. 5 have the following characteristics:
Characteristic 1: A structure of the receiving module shown in FIG. 2 is similar to that of the receiving module shown in FIG. 3, with a difference in that the LNAs support a different band. For example, the LNAs in the receiving module shown in FIG. 2 support a band of 3.3-4.2 GHz, and the LNAs in the receiving module shown in FIG. 3 support a band of 4.4-5.0 GHz.
Characteristic 2: The receiving module shown in FIG. 4 is a combination of the receiving module shown in FIG. 2 and the receiving module shown in FIG. 3, and new functional cells are added, so as to implement that a dual-frequency one-way receiving module receives a signal sent by a base station. The new functional cells are an input switch and an output switch.
Characteristic 3: The receiving module shown in FIG. 5 is a combination of two receiving modules shown in FIG. 4, and is configured to implement that a dual-frequency two-way receiving module receives a signal sent by a base station.

With reference to the foregoing three characteristics, when the four modules are analyzed, same functional cells in the modules and a quantity of the same functional cells in corresponding modules may be known. Specifically, there are the following cases:
Case 1: In the receiving module shown in FIG. 2, FIG. 4, or FIG. 5, the same functional cell is an N77 filter. The receiving module shown in FIG. 2 has one N77 filter, the receiving module shown in FIG. 4 has one N77 filter, and the receiving module shown in FIG. 5 has two N77 filters.
Case 2: In the receiving module shown in FIG. 3, FIG. 4, or FIG. 5, the same functional cell is an N79 filter. The receiving module shown in FIG. 3 has one N79 filter, the receiving module shown in FIG. 4 has one N79 filter, and the receiving module shown in FIG. 5 has two N79 filters.
Case 3: In the receiving module shown in FIG. 2, FIG. 4, or FIG. 5, the same functional cell is an N77 LNA. The receiving module shown in FIG. 2 has one N77 LNA, the receiving module shown in FIG. 4 has one N77 LNA, and the receiving module shown in FIG. 5 has two N77 LNAs.
Case 4: In the receiving module shown in FIG. 3, FIG. 4, or FIG. 5, the same functional cell is an N79 LNA. The receiving module shown in FIG. 3 has one N79 LNA, the receiving module shown in FIG. 4 has one N79 LNA, and the receiving module shown in FIG. 5 has two N79 LNAs.
Case 5: In the receiving module shown in FIG. 4 or FIG. 5, the same functional cell is an input switch. The receiving module shown in FIG. 4 has one input switch, and the receiving module shown in FIG. 5 has two input switches.
Case 6: In the receiving module shown in FIG. 4 or FIG. 5, the same functional cell is an output switch. The receiving module shown in FIG. 4 has one output switch, and the receiving module shown in FIG. 5 has two output switches.

Further, the minimum standard cells may be obtained by analyzing a greatest common divisor of a quantity of the same functional cells in case 1 to case 6.

It can be learned from analysis of case 1 that in the receiving module shown in FIG. 2, FIG. 4, or FIG. 5, a greatest common divisor of a quantity of N77 filters is 1, and therefore, the minimum standard cell may be one N77 filter. The receiving module shown in FIG. 2 includes one N77 filter, the receiving module shown in FIG. 4 includes one N77 filter, and the receiving module shown in FIG. 5 includes two N77 filters.

It can be learned from analysis of case 2 that in the receiving module shown in FIG. 3, FIG. 4, or FIG. 5, a greatest common divisor of a quantity of N79 filters is 1, and therefore, the minimum standard cell may be one N79 filter. The receiving module shown in FIG. 3 may include one N79 filter, the receiving module shown in FIG. 4 may include one N79 filter, and the receiving module shown in FIG. 5 includes two N79 filters.

It can be learned from analysis of case 3 and case 4 that the N77 LNAs and the N79 LNAs have the same structure, with a difference in that supported bands are different, and thus the N77 LNAs and the N79 LNAs may be considered as the same functional cells. Therefore, a broadband LNA technology may be used, so that one LNA can cover both the band supported by the N77 LNAs and the band supported by the N79 LNAs. For example, by implementing broadband LNAs, a coverage band range is 3.3-5.0 GHz. In this way, when the N77 LNAs and the N79 LNAs in FIG. 2 to FIG. 5 are replaced by broadband LNAs, it can be learned from a quantity of the LNAs in the receiving modules shown in FIG. 2 to FIG. 5 that a greatest common divisor of the quantity of the LNAs is 1, and therefore, the minimum standard cell may be one LNA. The receiving module shown in FIG. 2 includes one LNA, the receiving module shown in FIG. 3 includes one LNA, the receiving module shown in FIG. 4 includes two LNAs, and the receiving module shown in FIG. 5 includes four LNAs.

It can be learned from analysis of case 5 and case 6 that both the receiving module shown in FIG. 4 and the receiving module shown in FIG. 5 include the input switch and the input switch, and therefore, the input switch and the output switch may be integrated on the same wafer by using the same process (for example, an SOI process), so that the minimum standard cell for switches may be the input switch and the output switch. The receiving module shown in FIG. 4 includes one input switch and one output switch, and the one input switch and the one output switch are used as one minimum standard cell; and the receiving module shown in FIG. 5 includes two input switches and two output switches, and the two input switches and the two output switches are used as two minimum standard cells.

It should be noted that the same module may include at least one of the foregoing minimum standard cells, so that different radio frequency transmitting or receiving functions may be implemented by using a module including at least one minimum standard cell.

For a different receiving module, when minimum standard cells are determined, the minimum standard cells with the same function are cut on the same die based on a quantity of the minimum standard cells in the module, so that a quantity of wafer types may be reduced.

For example, in the receiving module shown in FIG. 2, FIG. 4, or FIG. 5, the minimum standard cell is one N77 filter. Therefore, the one N77 filter shown in FIG. 2 is cut on one die, the one N77 filter shown in FIG. 4 is cut on one die, and the two N77 filters shown in FIG. 5 are cut on one die. Further, in this embodiment of this application, pads with the same function of the N minimum standard cells with the same function are respectively connected to each other in the first die by metal wiring for an integrated circuit process, where N is greater than 1.

For ease of description, when N=4, the first minimum standard cells are LNAs, and the control lines are MIPI lines. For example, FIG. 12 is a schematic diagram of a layout wiring according to an embodiment of this application. As shown in FIG. 12, four LNAs (LNA1, LNA2, LNA3, and LNA4) are included, each LNA has four pads (VDD, VIO, SCLK, and SDATA), and adjacent LNAs connect pads with the same function to each other by metal wiring for an integrated circuit process.

It should be noted that the control lines described in this embodiment of this application may also be another type of control lines, which is not specifically limited.

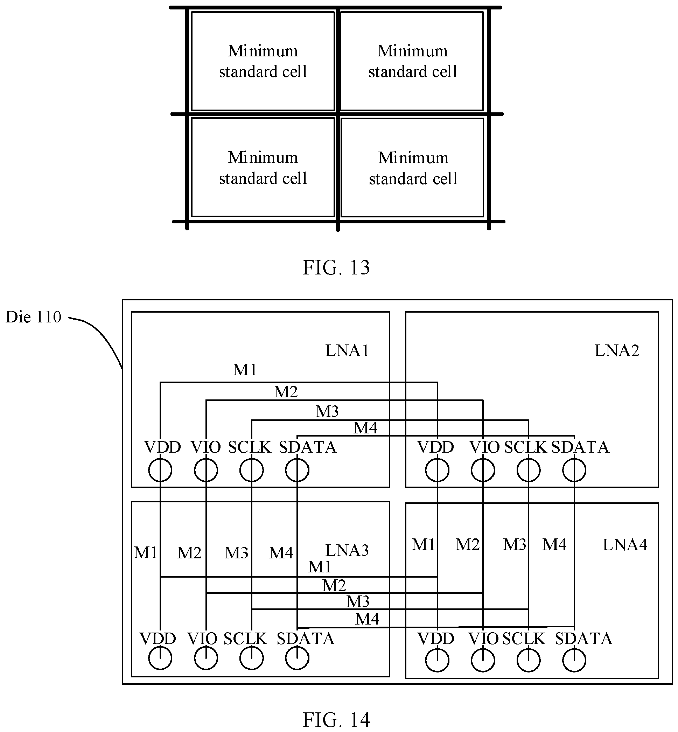

When pads with the same function of the N minimum standard cells with the same function are respectively connected to each other in the die, a scribing channel is disposed between two adjacent minimum standard cells. For example, FIG. 13 is a schematic diagram of a scribing channel according to an embodiment of this application. As shown in FIG. 13, wide black line segments in the figure are scribing channels, the scribing channels are disposed among four minimum basic cells, and the scribing channels may be a 60-80 µm (microns) circuit-free functional area for separating the minimum standard cells, and a cutter may cut along the scribing channels to implement each independent functional cell. In a semiconductor process, some process control monitor (process control monitor, PCM) cells may be placed in the scribing channels, such as metal oxide semiconductor field effect transistors (metal oxide semiconductor field effect transistors, MOSFETs), MIM capacitors, and poly resistors. In this way, the process can be controlled correctly by testing performance of these monitor cells during process manufacturing. When pads with the same function of the N minimum standard cells with the same function are respectively connected to each other in the die, a scribing channel is disposed between two adjacent minimum standard cells, and pads with the same function of the adjacent minimum standard cells are electrically connected respectively through the scribing channel. For ease of description, that the first minimum standard cells are LNAs (N=4) is used as an example for description.

For example, FIG. 14 is a schematic diagram of a layout wiring according to an embodiment of this application. As shown in FIG. 14, four LNAs (LNA1, LNA2, LNA3, and LNA4) are included, each LNA has four pads (VDD, VIO, SCLK, and SDATA), and a scribing channel is disposed between two adjacent LNAs. Pads with the same function of the adjacent LNAs are electrically connected respectively through the scribing channel. For example, the adjacent LNAs may connect the pads with the same function to each other by using metal wires, and the metal wires may include M1, M2, M3, and M4. VDDs of the adjacent LNAs are connected to each other by using the M1, VIOs of the adjacent LNAs are connected to each other by using the M2, SCLKs of the adjacent LNAs are connected to each other by using the M3, and SDATAs of the adjacent LNAs are connected to each other by using the M4.

It should be noted that metal wires between the pads with the same function of the adjacent LNAs may be set to be M1, M2, M3, or M4 according to an actual application scenario. This is not limited in this embodiment of this application.

It should be noted that, that pads with the same function of the adjacent minimum standard cells are electrically connected respectively through the scribing channel means that a scribing channel between adjacent minimum standard cells is not cut in the same die. In this way, an electrical connection function between the adjacent minimum standard cells may be implemented.

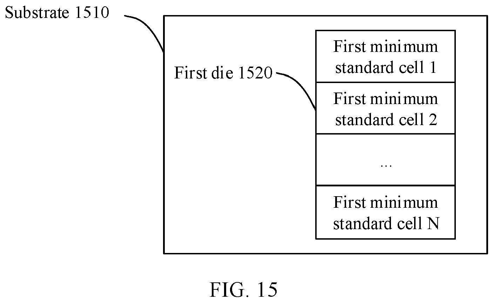

For example, FIG. 15 is a schematic diagram of a module 150 according to an embodiment of this application. As shown in FIG. 15, the module 150 includes a substrate 1510 and a first die 1520, and the first die 1520 is disposed on the substrate 1510.

In this embodiment of this application, the first die 1520 includes N first minimum standard cells with the same function, and the first minimum standard cells are minimum repetitive functional cells in the M modules with the same functional cell; where N is greater than 1, and M is greater than 1. Pads with the same function of the N first minimum standard cells with the same function are respectively connected to each other in the first die 1520. This schematic diagram can be described adaptively with reference to FIG. 12, and details are not described herein again.

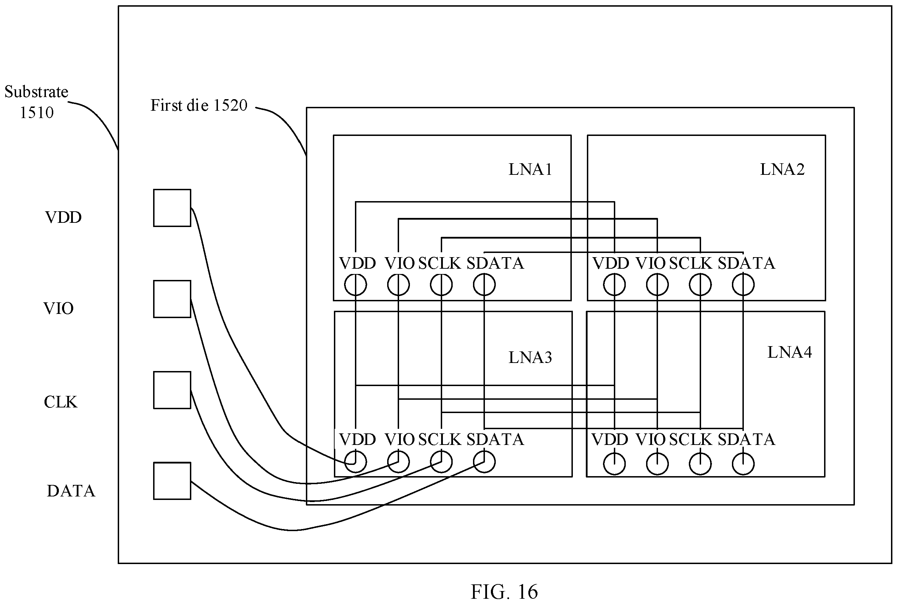

In this embodiment of this application, pins of the substrate 1510 need to be connected to pads of any one of the first minimum standard cells. For ease of description, when that the first minimum standard cells are LNAs (N=4) is used as an example for description, for example, FIG. 16 is a schematic diagram of a layout wiring according to an embodiment of this application. As shown in FIG. 16, scribing channels are disposed among the LNAs, and pads with the same function of adjacent LNAs are electrically connected respectively through the scribing channels. In this way, when pins VDD, VIO, CLK, and DATA of the substrate 1510 are connected to pads VDD, VIO, SCLK, and SDATA of the LNA3, an interconnection between the LNA3 and other LNAs can reduce substrate wires, and reduce gaps among the LNAs, so as to save module space.

It should be noted that the layout wiring shown in FIG. 16 is described when a die is included on the substrate. If a plurality of dies are included on the substrate, pads of adj acent minimum standard cells with the same function among the dies are also connected, which is not shown in the figure. In this embodiment of this application, for an implementation for determining the first minimum standard cells, reference may be made to the foregoing implementation for determining the minimum standard cells, and details are not described herein again. It may be understood that an implementation for determining the first minimum standard cells may also be set according to an actual application scenario. This is not limited in this embodiment of this application.

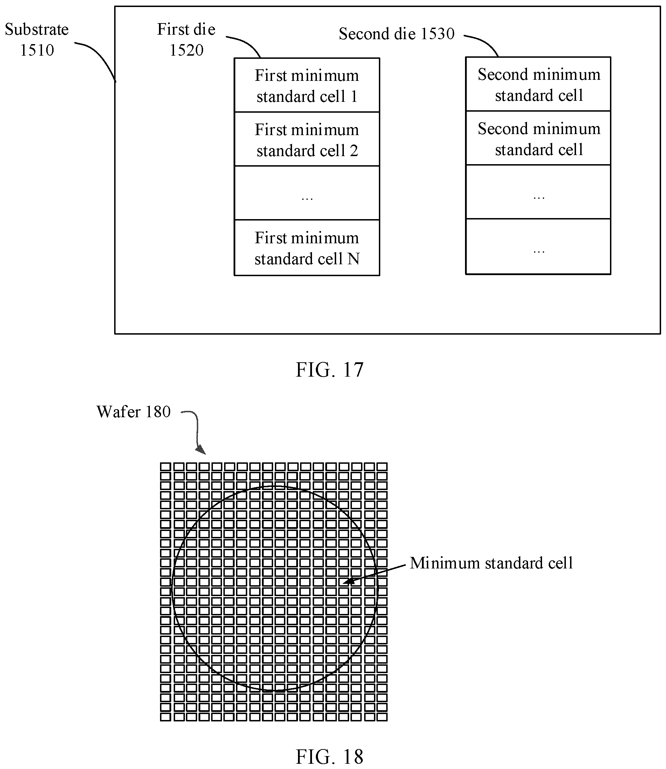

On the basis of the module 150 shown in FIG. 15, for example, FIG. 17 is a schematic diagram of a module 150 according to an embodiment of this application. As shown in FIG. 17, the module 150 further includes: a second die 1530, the second die includes one or more second minimum standard cells with the same function. It may be understood that the second die 1530 may be the same as the first die 1520, or the second die 1530 may be different from the first die 1520, and may be set according to an actual application scenario. This is not limited in this embodiment of this application.

In this embodiment of this application, the first die 1520 and the second die 1530 are cut from a wafer. For example, FIG. 18 is a schematic diagram of a wafer 180 according to an embodiment of this application. As shown in FIG. 18, the wafer may include X minimum standard cells with the same function, or it may be understood that the wafer is a rectangle including a plurality of minimum standard cells. Generally, the wafer may have a size of 6 inches, 8 inches, or 12 inches. A specific size of the wafer may be set according to an actual application scenario. This is not limited in this embodiment of this application.

It should be noted that a scribing channel is disposed between two adjacent minimum standard cells, and pads with the same function of the adjacent minimum standard cells are electrically connected respectively through the scribing channel. For ease of description, that a wafer includes four minimum standard cells is used as an example for description.

Generally, in the wafer shown in FIG. 18, a die may be obtained by cutting minimum standard cells in a circular region, and the die may be the first die 1520 or the second die 1530. This is not limited in this embodiment of this application.

Because a quantity of the minimum standard cells in the die is different, a requirement of modules needs to be considered when the die is cut from the wafer. For ease of description, with reference to the receiving modules shown in FIG. 2 to FIG. 5, the modules are made from cut dies by cutting minimum standard cells needed in the modules into the same die.

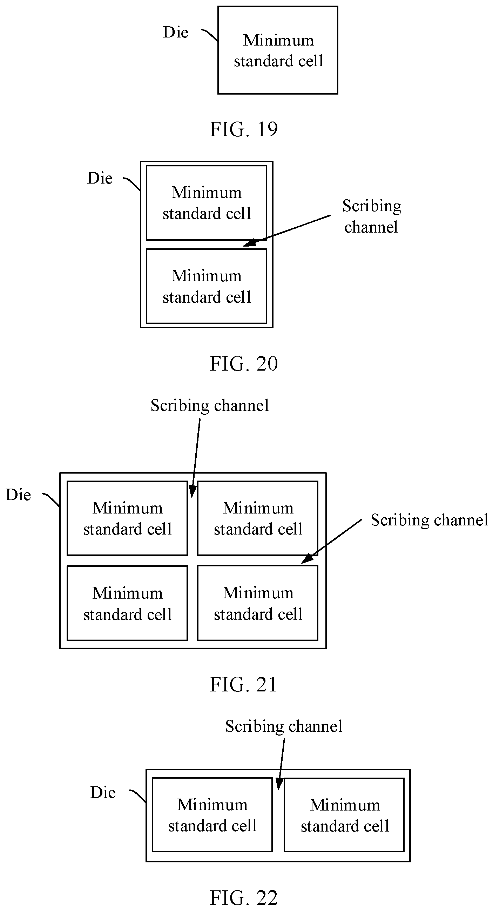

For example, FIG. 19 is a schematic diagram of a wafer cutting method according to an embodiment of this application. As shown in FIG. 19, a minimum standard cell is used as a cutting cell for cutting along a scribing channel, so as to obtain a die including a minimum standard cell. Therefore, when the minimum standard cell is an N77 filter, the die may be used to make the receiving module shown in FIG. 2; when the minimum standard cell is an N79 filter, the die may be used to make the receiving module shown in FIG. 3; when the minimum standard cell is an amplifier, the die may be used to make the receiving module shown in FIG. 2 or FIG. 3; and when the minimum standard cell is an input switch and an output switch, the die may be used to make the receiving module shown in FIG. 4.

For example, FIG. 20 is a schematic diagram of a wafer cutting method according to an embodiment of this application. As shown in FIG. 20, two minimum standard cells are used as a minimum cutting cell for cutting along a scribing channel, so as to obtain a die including two minimum standard cells, and the scribing channel between the two minimum standard cells is not cut. Therefore, when the minimum standard cells are N77 filters, the die may be used to make the receiving module shown in FIG. 4; when the minimum standard cells are N79 filters, the die may be used to make the receiving module shown in FIG. 4; when the minimum standard cells are amplifiers, the die may be used to make the receiving module shown in FIG. 4; and when the minimum standard cells are input switches and output switches, the die may be used to make the receiving module shown in FIG. 5.

For example, FIG. 21 is a schematic diagram of a wafer cutting method according to an embodiment of this application. As shown in FIG. 21, four minimum standard cells are used as a minimum cutting cell for cutting a wafer along scribing channels, so as to obtain a die including four minimum standard cells, and the scribing channels among the four minimum standard cells are not cut. Therefore, when the minimum standard cells are amplifiers, the die may be used to make the receiving module shown in FIG. 5.

It should be noted that for a module including n minimum standard cells, different combination forms may be selected according to requirements of an inner space of the module or according to requirements of an isolation between different dies; where n is greater than or equal to 1. The requirements of an inner space of the module may be understood as follows: the inner space of the module requires minimum standard cells in the form of a rectangular horizontal arrangement (1 row and n columns), or requires minimum standard cells in the form of a rectangular vertical arrangement (n rows and 1 column), or requires minimum standard cells in the form of a square-like arrangement (p rows and q columns, where p*q=n); and the requirements of an isolation between different dies may be understood as follows: two dies require a higher isolation of pads. With reference to the wafer cutting method shown in FIG. 20, it can be learned that a cutting manner shown in FIG. 20 is performed in the form of 2 rows and 1 column, or in the form of 1 row and 2 columns. Specifically, for a schematic diagram in which minimum standard cells in a die are cut in the form of 1 row and 2 columns, reference may be made to FIG. 22, and details are not described herein again.

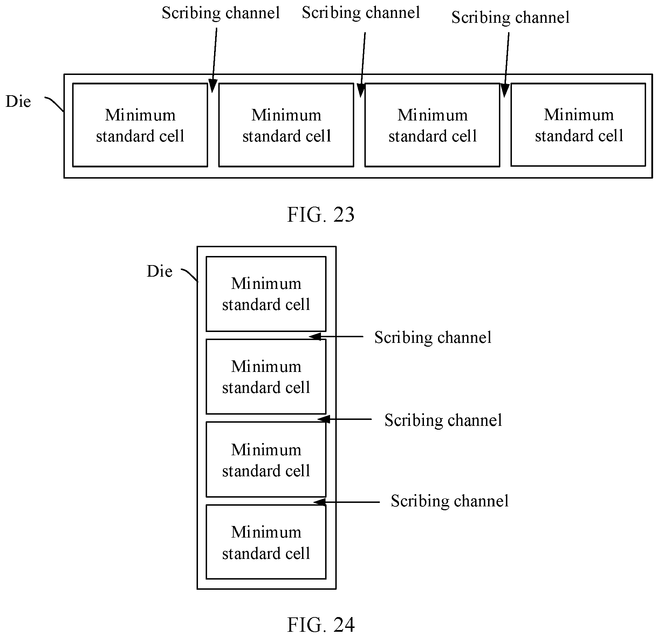

With reference to the wafer cutting method shown in FIG. 21, it can be learned that a cutting manner shown in FIG. 21 is performed in the form of 2 rows and 2 columns, or in the form of 4 rows and 1 column or 1 row and 4 columns. Specifically, for a schematic diagram in which cutting is performed in the form of 4 rows and 1 column, reference may be made to FIG. 23; and for a schematic diagram in which cutting is performed in the form of 1 row and 4 columns, reference may be made to FIG. 24. Details are not described herein again.

In the cutting methods shown in FIG. 20 to FIG. 24, pads with the same function of adjacent minimum standard cells are connected to each other, which is not shown in the figure. To better describe the cutting methods, the following describes a cutting method after pads with the same function of the adjacent minimum standard cells are electrically connected respectively through a scribing channel when pads with the same function of the adjacent minimum standard cells are connected to each other.

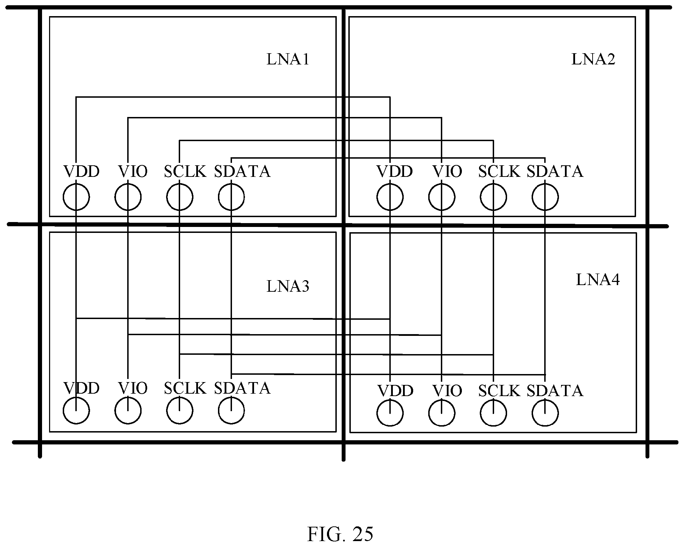

For ease of description, that a wafer includes four LNAs is used as an example for description. The four LNAs are LNA1, LNA2, LNA3, and LNA4, each LNA includes four pads, and the four pads are power pads VDD and VIO, a clock pad CLK, and a data pad DATA. Therefore, pads with the same function of adjacent LNAs may be electrically connected through a scribing channel. For example, FIG. 25 is a schematic diagram of a wafer cutting method according to an embodiment of this application. As shown in FIG. 25, black lines in the figure indicate scribing channels. Therefore, cutting may be performed along the scribing channels according to the method shown in FIG. 19. In this way, an LNA can be cut on a die, and then a module may be made from the die. For example, the die may be used to make the receiving module shown in FIG. 2 or FIG. 3.

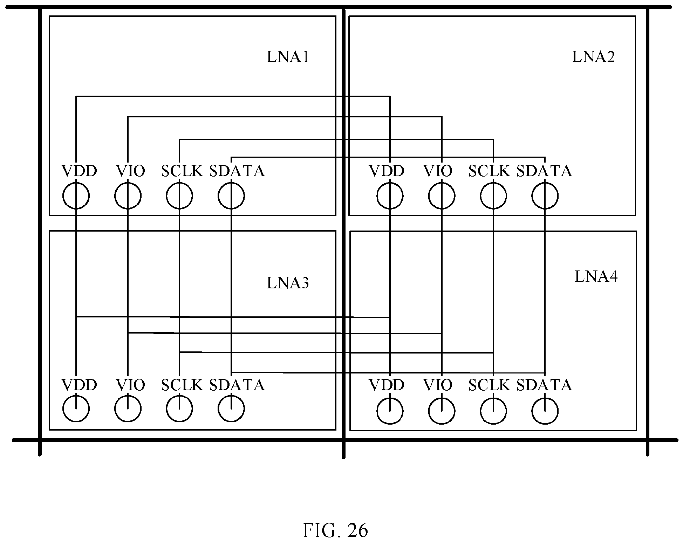

For example, FIG. 26 is a schematic diagram of a wafer cutting method according to an embodiment of this application. As shown in FIG. 26, the LNA1 and the LNA3 may be cut on a die, and the LNA2 and the LNA4 may be cut on a die along a scribing channel according to the cutting method shown in FIG. 20. In this way, two dies including two amplifiers may be obtained, respectively, and then a module may be made from the dies. For example, the dies may be used to make the receiving module shown in FIG. 4.

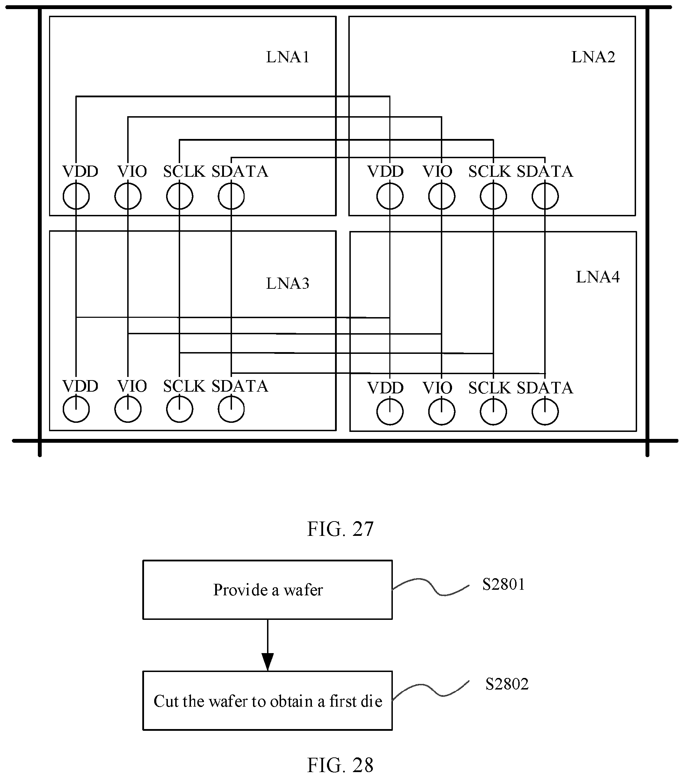

For example, FIG. 27 is a schematic diagram of a wafer cutting method according to an embodiment of this application. As shown in FIG. 27, the LNA1, the LNA2, the LNA3, and the LNA4 may be cut on the same die along scribing channels according to the method shown in FIG. 21. In this way, a die including four amplifiers may be obtained, and then a module may be made from the die. For example, the die may be used to make the receiving module shown in FIG. 5.

It should be noted that, when the wafer is cut, the cutting method is not limited to the cutting methods shown in FIG. 25 to FIG. 27, and any cutting method that enables a die to include n minimum standard cells is allowed. This is not limited in this embodiment of this application. Referring to FIG. 19 to FIG. 27, for example, FIG. 28 is a schematic diagram of a method for manufacturing a die according to an embodiment of this application. As shown in FIG. 28, the method may include the following steps:
S2801: Provide a wafer.

In this embodiment of this application, the wafer may include X minimum standard cells with the same function; among the X minimum standard cells with the same function, a scribing channel is disposed between two adjacent minimum standard cells, and pads with the same function of the adjacent minimum standard cells are electrically connected respectively through the scribing channel. For a schematic diagram of the wafer, reference may be made to the example shown in FIG. 18, and for a schematic diagram of the scribing channel between the minimum standard cells, reference may be made to the example shown in FIG. 13. Details are not described herein again. S2802: Cut the wafer to obtain a first die.

In this embodiment of this application, the first die includes K minimum standard cells with the same function, and the minimum standard cells include any one of: a filter cell, an amplifier cell, or a switch cell; where K is an integer greater than or equal to 1.

It should be noted that the minimum standard cells may be determined based on a quantity of same functional cells in each module. In this way, a die matched with the module may be obtained by cutting the wafer by using the cutting methods shown in FIG. 19 to FIG. 27. Therefore, the module may be made from the die.

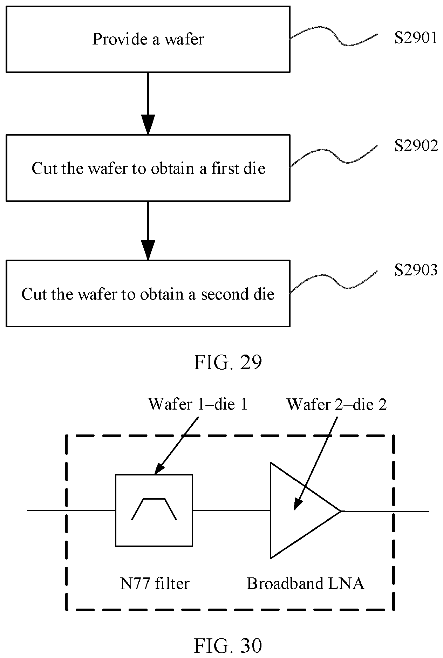

On the basis of the embodiment shown in FIG. 28, for example, FIG. 29 is a schematic diagram of a method for manufacturing a die according to an embodiment of this application. As shown in FIG. 29, the method may include the following steps:
S2901: Provide a wafer.
S2902: Cut the wafer to obtain a first die.
S2903: Cut the wafer to obtain a second die.

In this embodiment of this application, the second die includes L minimum standard cells with the same function, where L is an integer greater than or equal to 1, and the quantity L of the second die is not equal to the quantity K of the first die. For example, when the wafer is cut by using the cutting method shown in FIG. 20, the first die includes two minimum basic cells, that is, K=2, and when the wafer is further cut, the cutting method shown in FIG. 21 may be used. In this way, the second die includes four minimum basic cells, that is, L=4. Therefore, K and L are not equal. In this way, by cutting a wafer in different manners, the wafer can be fully used without causing waste of the wafer.

It should be noted that a wafer includes minimum standard cells with the same function. For example, a wafer includes a filter cell, another wafer includes an amplifier cell, and still another wafer includes a switch cell. In this way, dies for implementing different functions may be obtained by cutting different types of wafers, and then dies cut from a plurality of wafers can be reused to make different modules.

In the receiving modules shown in FIG. 2 to FIG. 5, different minimum standard cells are included, or it may be understood that different types of wafers are included, or it may be understood that different types of dies are included. The minimum standard cells may be an N77 filter, an N79 filter, an amplifier, an input switch, and an input switch.

For ease of description, a wafer including an N77 filter cell is referred to as a wafer 1, and the wafer 1 may be cut to obtain a die 1; a wafer including a broadband amplifier cell is referred to as a wafer 2, and the wafer 2 may be cut to obtain a die 2; a wafer including an N79 filter cell is referred to as a wafer 3, and the wafer 3 may be cut to obtain a die 3; and a wafer including an input switch cell and an output switch cell is referred to as a wafer 4, and the wafer 4 may be cut to obtain a die 4; where a quantity of minimum standard cells in the dies may be set according to actual module requirements. This is not limited in this embodiment of this application.

For the receiving module shown in FIG. 2, for example, FIG. 30 is a schematic diagram of a wafer type according to an embodiment of this application. As shown in FIG. 30, the receiving module includes two types of wafers: a wafer 1 and a wafer 2. Because the receiving module includes an N77 filter and an amplifier, when the wafer 1 is cut, a die 1 may be obtained by using the cutting method shown in FIG. 19; and when the wafer 2 is cut, a die 2 may be obtained by using the cutting method shown in FIG. 19.

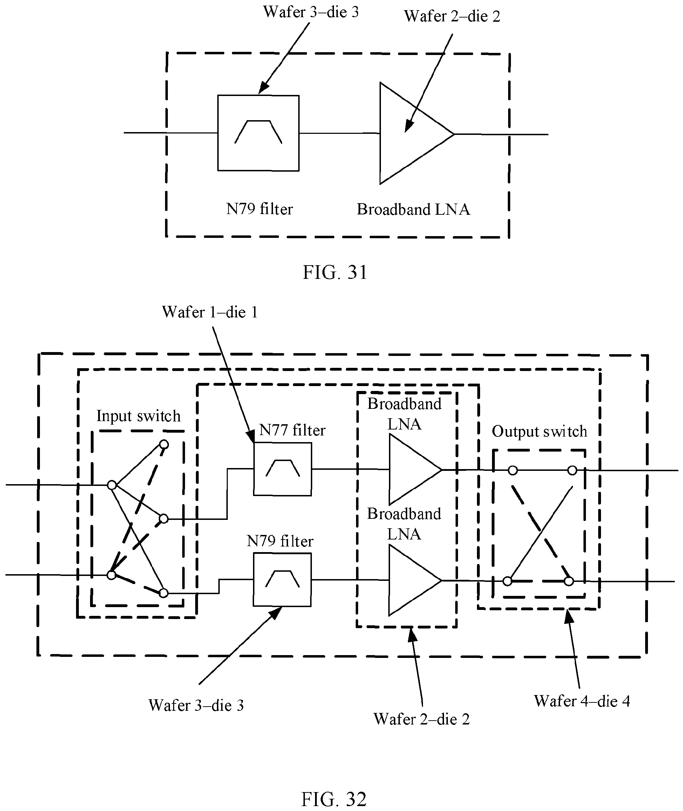

For the receiving module shown in FIG. 3, for example, FIG. 31 is a schematic diagram of a wafer type according to an embodiment of this application. As shown in FIG. 31, the receiving module includes two types of wafers: a wafer 2 and a wafer 3. With reference to the wafer type shown in FIG. 30, the wafer 2 may be reused in the receiving module shown in FIG. 31, thereby reducing a quantity of wafer types compared with the conventional technology. Because the receiving module includes an N79 filter, when the wafer 3 is cut, a die 3 may be obtained by using the cutting method shown in FIG. 19.

For the receiving module shown in FIG. 4, for example, FIG. 32 is a schematic diagram of a wafer type according to an embodiment of this application. As shown in FIG. 32, the receiving module includes four types of wafers: a wafer 1, a wafer 2, a wafer 3, and a wafer 4. With reference to the wafer types shown in FIG. 30 and FIG. 31, the wafer 1, the wafer 2, and the wafer 3 may be reused in the receiving module shown in FIG. 32. Compared with the conventional technology, the wafers can be reused, so that a development cycle of the wafers can be reduced.

It should be noted that in the receiving module shown in FIG. 32, although the wafer 2 is reused, when the wafer 2 is cut, a die 2 may be obtained by using the cutting method shown in FIG. 20 or FIG. 22, and the die 2 includes two amplifier cells.

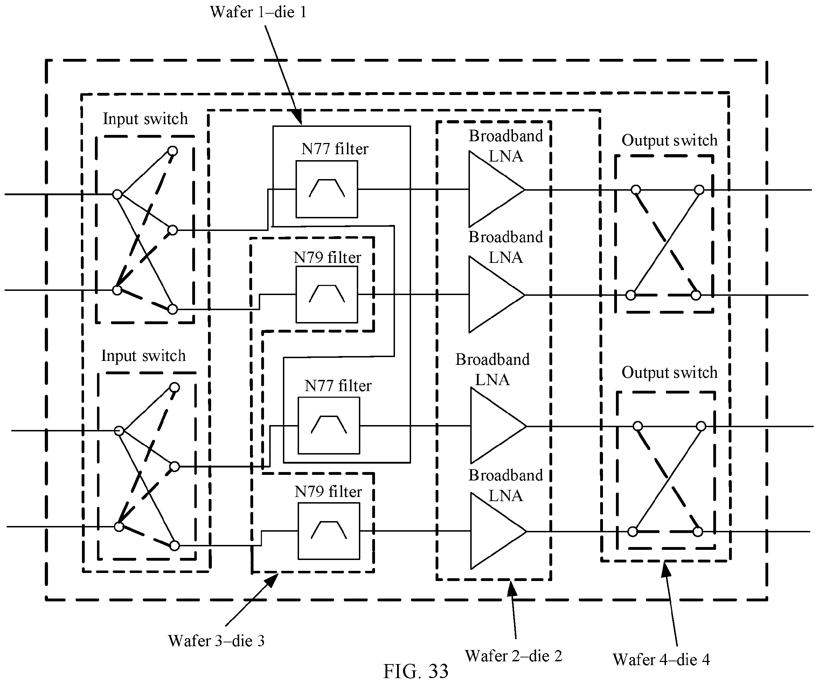

For the receiving module shown in FIG. 5, for example, FIG. 33 is a schematic diagram of a wafer type according to an embodiment of this application. As shown in FIG. 33, the receiving module includes four types of wafers: a wafer 1, a wafer 2, a wafer 3, and a wafer 4. With reference to the wafer types shown in FIG. 30, FIG. 31 and FIG. 32, the wafer 1, the wafer 2, the wafer 3, and the wafer 4 may be reused in the receiving module shown in FIG. 33. Compared with the conventional technology, the wafers can be reused, so that a development cycle of the wafers can be reduced.

It should be noted that in the receiving module shown in FIG. 33, when the wafer 1 is cut, a die 1 may be obtained by using the cutting method shown in FIG. 20, and the die 1 includes two N77 filter cells; when the wafer 2 is cut, a die 2 may be obtained by using the cutting method shown in FIG. 24, and the die 2 includes four amplifier cells; or the wafer is cut by using the cutting method shown in FIG. 21 or FIG. 23 according to requirements of module space, which is not limited in this embodiment of this application; when the wafer 3 is cut, a die 3 may be obtained by using the cutting method shown in FIG. 20, and the die 3 includes two N79 filter cells; and when the wafer 4 is cut, a die 4 may be obtained by using the cutting method shown in FIG. 20, and the die 4 includes two input cells and two output cells.

According to comparison between the schematic diagrams of the wafer types shown in FIG. 30 to FIG. 33 and the schematic diagrams of the wafer types shown in FIG. 5 to FIG. 9 in the conventional technology, a quantity of the wafer types in the conventional technology is 10, while in the method for cutting based on minimum standard cells designed in this embodiment of this application, a quantity of the wafer types is 4. Therefore, the quantity of the wafer types is reduced, so as to resolve the problem that wafers are independently developed for different modules, and resolve problems such as a long development cycle and difficulty in stocking of wafers. According to the schematic diagrams of the wafer types shown in FIG. 30 to FIG. 33, for example, an embodiment of this application provides a method for simultaneously making M modules. The M modules include different dies, and the different dies are cut from different types of wafers. In this way, based on the wafers, the M modules may be made from dies cut from the wafers, so that the M modules can implement radio frequency transmitting or receiving functions in different mobile systems.

In this embodiment of this application, the M modules need to be divided by functions. Because different functions are implemented by using different dies, and different dies are cut from different wafers, G wafers need to be provided. In this way, G dies can be obtained by cutting the G wafers, and the G dies are respectively used to implement G functions, where G is greater than 1. Further, a plurality of dies among the G dies are combined and reused, so that the M modules can be made. For example, if a wafer 1 including an N77 filter cell is provided, the wafer 1 may be cut to obtain an N77 filter die; or if a wafer 2 including a broadband amplifier cell is provided, the wafer 2 may be cut to obtain a broadband amplifier die, and then the receiving module shown in FIG. 2 may be made by combining the N77 filter die and the broadband amplifier die.

For example, an embodiment of this application provides a radio frequency system, including: an antenna and the module 150 shown in FIG. 15, where the module 150 includes a substrate 1510 and a first die 1520, and the first die 1520 is disposed on the substrate 1510; or the radio frequency system includes: an antenna and the module 150 shown in FIG. 17, where the module 150 includes a substrate 1510, a first die 1520, and a second die 1530, and both the first die 1520 and the second die 1530 are disposed on the substrate 1510.

In the descriptions of embodiments of this application, it should be noted that, unless otherwise explicitly specified and defined, the terms "mount", "connect", and "connection" should be understood in a broadest sense, for example, fixed connection, indirect connection by a medium, or internal communication between two elements or an interaction relationship between the two elements. A person of ordinary skill in the art can understand specific meanings of the foregoing terms in embodiments of this application based on a specific situation.

The apparatus or element referred to in or implied in embodiments of this application needs to have a specific orientation, be constructed and operated in a specific orientation, and therefore cannot be construed as a limitation on embodiments of this specification. In the descriptions of embodiments of this application, "a plurality of" means two or more, unless otherwise specifically defined.

In the specification of embodiments, claims, and accompanying drawings of this application, the terms "first", "second", "third", "fourth", and the like (if existent) are intended to distinguish between similar objects but do not necessarily indicate a specific order or sequence. It should be understood that the data termed in such a way is interchangeable in proper circumstances, so that embodiments described herein can be implemented in orders except the order illustrated or described herein. In addition, the terms "including" and "having" and any of their variants are intended to cover non-exclusive inclusions. For example, a process, method, system, product, or device that includes a series of steps or cells is not necessarily limited to those steps or cells clearly listed, and may include other steps or cells that are not clearly listed or are inherent to the process, method, product, or device.

Finally, it should be noted that the foregoing embodiments are merely intended for describing the technical solutions of embodiments of this application, but not for limiting this application. Although embodiments of this application are described in detail with reference to the foregoing embodiments, those of ordinary skill in the art should understand that they may still make modifications to the technical solutions described in the foregoing embodiments, or make equivalent replacements to some or all of the technical features therein. These modifications or replacements do not make the essence of the corresponding technical solutions deviate from the scope of the technical solutions of embodiments of this application.

## Claims

1. A method for manufacturing a die, comprising:
providing a wafer, wherein the wafer comprises X minimum standard cells with the same function, a scribing channel is disposed between two adjacent minimum standard cells among the X minimum standard cells with the same function, and pads with the same function of the adjacent minimum standard cells are electrically connected through the scribing channel by metal wiring for an integrated circuit process; and the minimum standard cells are minimum repetitive functional cells in a plurality of receiving modules with the same functional cell;
cutting the wafer to obtain a first die, wherein the first die comprises K minimum standard cells with the same function, and K is an integer greater than or equal to 1; and
cutting the wafer to obtain a second die, wherein the second die comprises L minimum standard cells with the same function, L is an integer greater than or equal to 1, and L and K are not equal; wherein
the minimum standard cells comprise any one of: a filter cell, an amplifier cell, or a switch cell, the amplifier cell is broadband low noise amplifiers, and the broadband low noise amplifiers support operating frequency ranges of N77 band low noise amplifiers and N79 band low noise amplifiers.

2. The method according to claim 1, wherein the plurality of receiving modules are dual-frequency two-way receiving modules that comprise two input switches, two N77 filters, two N79 filters, two N77 low noise amplifiers, two N79 low noise amplifiers, and two output switches that are sequentially connected, the N77 low noise amplifiers and the N79 low noise amplifiers are the broadband low noise amplifiers, and the four broadband low noise amplifiers are cut together; the input switches and the output switches are the switch cell, and the two input switches and the two output switches are cut together; the N77 filters are the filter cell, and the two N77 filters are cut together; and each N79 filter is another filter cell, and the two N79 filters are cut together.

3. The method according to claim 1 or 2, wherein the N77 band low noise amplifiers have an operating frequency range of 3.3-4.2 GHz, and the N79 band low noise amplifiers have an operating frequency range of 4.4-5.0 GHz.

4. A method for simultaneously making M modules, wherein the M modules comprise different dies and are configured to implement radio frequency transmitting or receiving functions in different mobile systems, and the method comprises:
dividing the M modules by functions, wherein different functions are implemented by different dies; the dies comprise one or more minimum standard cells with the same function; the minimum standard cells are minimum repetitive functional cells in the M modules with the same functional cell, and M is greater than 1; wherein
each of the M modules comprises different dies;
cutting G wafers to obtain G dies, wherein the G dies are used to implement G functions respectively, and G is greater than 1; and
combining and reusing a plurality of dies of the G dies to make the M modules respectively; wherein
among the minimum standard cells with the same function, pads with the same function are respectively connected to each other in the dies by metal wiring for an integrated circuit process;
a scribing channel is disposed between two adjacent minimum standard cells, and pads with the same function of the adjacent minimum standard cells are electrically connected respectively through the scribing channel; and
the minimum standard cells comprise any one of: a filter cell, an amplifier cell, or a switch cell, the amplifier cell is broadband low noise amplifiers, and the broadband low noise amplifiers support operating frequency ranges of N77 band low noise amplifiers and N79 band low noise amplifiers.

5. The method according to claim 4, wherein the M modules are dual-frequency two-way receiving modules, the dual-frequency two-way receiving modules comprise two input switches, two N77 filters, two N79 filters, two N77 low noise amplifiers, two N79 low noise amplifiers, and two output switches that are sequentially connected, the N77 low noise amplifiers and the N79 low noise amplifiers are the broadband low noise amplifiers, and the four broadband low noise amplifiers are cut together; the input switches and the output switches are the switch cell, and the two input switches and the two output switches are cut together; the N77 filters are the filter cell, and the two N77 filters are cut together; and each N79 filter is another filter cell, and the two N79 filters are cut together.

6. The method according to claim 4 or 5, wherein the N77 band low noise amplifiers have an operating frequency range of 3.3-4.2 GHz, and the N79 band low noise amplifiers have an operating frequency range of 4.4-5.0 GHz.
